## Europäisches Patentamt
## European Patent Office
## Office européen des brevets

(19)

(11) Veröffentlichungsnummer: **0 144 977**
**B1**

(12) **EUROPÄISCHE PATENTSCHRIFT**

(45) Veröffentlichungstag der Patentschrift:
**14.12.88**

(21) Anmeldenummer: **84114846.3**

(22) Anmeldetag: **06.12.84**

(51) Int. Cl.⁴: **H 03 K 17/13,** H 01 L 27/14

(54) Schaltungsanordnung zum Ansteuern eines Thyristors mit Licht.

(30) Priorität: **08.12.83 DE 3344476**

(43) Veröffentlichungstag der Anmeldung:
**19.06.85 Patentblatt 85/25**

(45) Bekanntmachung des Hinweises auf die Patenterteilung:
**14.12.88 Patentblatt 88/50**

(84) Benannte Vertragsstaaten:
**CH DE FR GB IT LI**

(56) Entgegenhaltungen:
**DE-A-2 738 186**
**US-A-4 413 193**

(73) Patentinhaber: **Siemens Aktiengesellschaft Berlin und München, Wittelsbacherplatz 2, D-8000 München 2 (DE)**

(72) Erfinder: **Tihanyi, Jenö, Dr. Ing., Windeckstrasse 1d, D-8000 München 70 (DE)**
Erfinder: **Fellinger, Christine, Ing., Germersheimerstrasse 5, D-8000 München 90 (DE)**
Erfinder: **Leipold, Ludwig, Dipl.- Ing., Strassberger Strasse 125, D-8000 München 40 (DE)**

EP 0 144 977 B1

**Beschreibung**

Die Erfindung bezieht sich auf eine Schaltungsanordnung zum Ansteuern mindestens eines an einer Wechselspannung liegenden Thyristors mit einem Fototransistor und mit einem Hilfstransistor, der eine Zündung des Thyristors nur in der Nähe des Nulldurchgangs der Wechselspannung ermöglicht.

Eine solche Schaltungsanordnung ist z. B. in "Siemens Components", 20 (1982), Heft 3, Seite 83/84 in Verbindung mit Bild 2 beschrieben worden. Bei dieser Schaltungsanordnung liegt der Basisanschluß des Hilfstransistors über einen Widerstand an der Wechselspannung. Die Kollektor-Emitterstrecke des Hilfstransistors liegt der Gate-Katodenstrecke des zu zündenden Thyristors parallel. Steigt nun die Wechselspannung von Null ausgehend auf einen bestimmten Wert, so wird der Hilfstransistor leitend und schließt die Gate-Katodenstrecke des Thyristors kurz. Der Thyristor kann dann nicht mehr gezündet werden. Eine Zündung ist nur möglich, solange die Wechselspannung einen bestimmten Wert nicht überschritten hat und der zwischen Basisanschluß und Emitteranschluß des Hilfstransistors liegende Fototransistor leitend gesteuert ist.

Bei dieser Schaltungsanordnung fließt im nicht gezündeten Zustand des Thyristors ein Ruhestrom, der dem Basisstrom des Hilfstransistors entspricht. Der Erfindung liegt die Aufgabe zugrunde, eine Schaltungsanordnung der beschriebenen Art derart weiterzubilden, daß der Ruhestrom für eine solche Anordnung stark herabgesetzt wird.

Die Erfindung ist gekennzeichnet durch folgende Merkmale:

a) Die Kollektor-Emitterstrecke des Fototransistors liegt zwischen einer ersten von zwei Wechselspannungsklemmen und dem Gateanschluß des Thyristors,

b) zwischen dem Basisanschluß des Fototransistors und der zweiten Wechselspannungsklemme liegt die Source-Drainstrecke eines IGFET vom Anreicherungstyp,

c) zwischen dem Gateanschluß des IGFET und der ersten Wechselspannungsklemme liegt eine Fotodiode,

d) die Fotodiode ist derart gepolt, daß sie in Sperrichtung vorgespannt ist, wenn am Thyristor Spannung in Durchlaßrichtung anliegt,

e) der IGFET hat eine höhere Einsatzspannung als der Fototransistor und eine geringere Eingangskapazität als dieser.

Weiterbildungen der Erfindung sind Gegenstand der Unteransprüche.

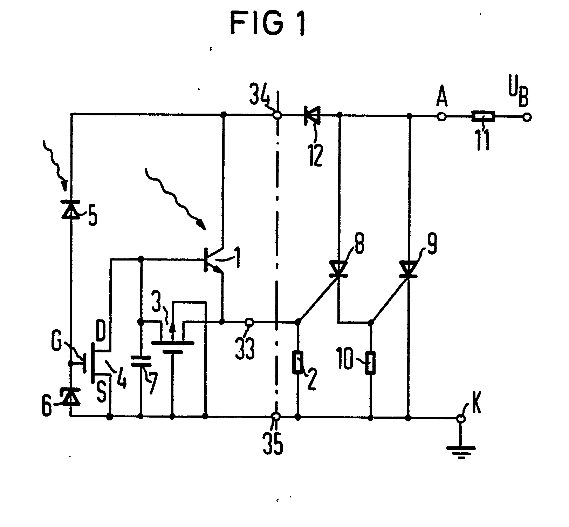

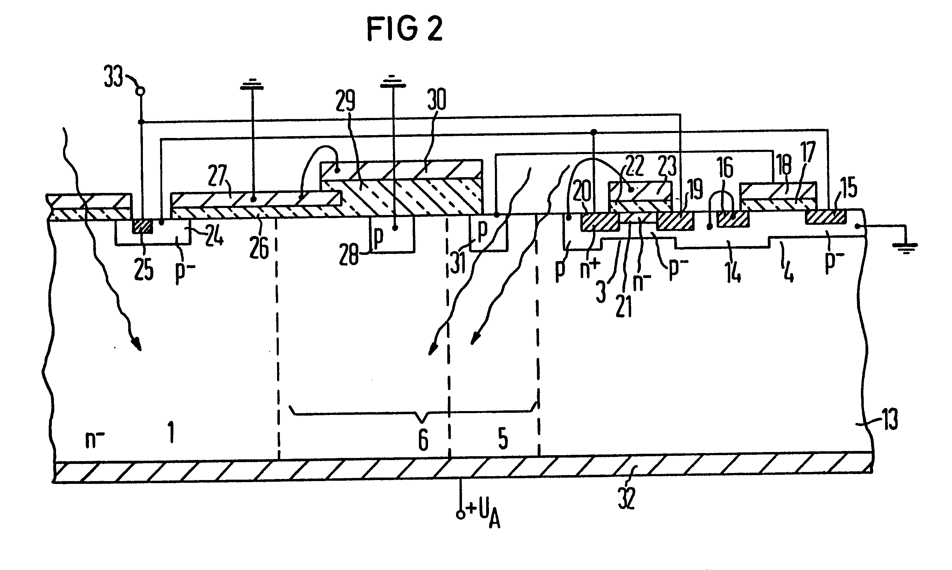

Die Erfindung wird an Hand eines Ausführungsbeispiels in Verbindung mit den Fig. 1 und 2 näher erläutert. Es zeigen:

Fig. 1    die Schaltungsanordnung gemäß der Erfindung und

Fig. 2    einen Schnitt durch eine integrierte Anordnung der links von der gestrichelten Linie nach Fig. 1 liegenden Bestandteile der Schaltung.

Die Schaltungsanordnung nach Fig. 1 enthält einen Fototransistor 1, dessen Kollektoranschluß mit einer ersten Wechselspannungsklemme 34 verbunden ist. Diese Klemme kann direkt mit einer Anodenklemme A verbunden sein. Dazwischen kann zum Schutz des Fototransistors 1 gegen Sperrspannungsbelastung eine Diode 12 geschaltet sein. Zwischen dem Basisanschluß des Fototransistors 1 und einer zweiten Wechselspannungsklemme 35 liegt die Source-Drainstrecke eines IGFET 4 vom Anreicherungstyp, der beispielsweise ein MOSFET sein kann. Die zweite Wechselspannungsklemme kann direkt mit einer Katodenklemme K verbunden sein, die z. B. an Masse liegt. Der Gateanschluß G des IGFET 4 ist über eine Fotodiode 5 mit der Klemme 34 verbunden. Zwischen dem Gateanschluß G und dem Sourceanschluß S des IGFET 4 liegt vorzugsweise eine Zenerdiode 6, die die Gate-Sourcespannung für den IGFET 4 begrenzen soll. Zwischen dem Basisanschluß des Fototransistors und der Klemme 35 kann ein Kondensator 7 liegen. Zwischen dem Basisanschluß des Fototransistors 1 und seinem Emitteranschluß liegt zweckmäßigerweise ein Widerstand 3, der z. B. ein IGFET vom Verarmungstyp sein kann, dessen Gateanschluß mit der Klemme 35 verbunden ist. Die Fotodiode wird durch die Lichtquelle für den Fototransistor oder durch eine dazu synchron arbeitende zweite Lichtquelle beleuchtet.

Der Leistungsteil besteht aus mindestens einem Thyristor, dessen Anoden-Katodenstrecke zwischen den Klemmen A und K liegt. Der Thyristor kann jedoch auch ein Thyristor mit einem den Zündstrom verstärkenden Hilfsthyristor sein, wie in Fig. 1 dargestellt. Dann ist der Thyristor 9 der Hauptthyristor. Sein Steuerstrom wird durch den Laststrom des Hilfsthyristors 8 gebildet, der seinerseits zwischen den Klemmen A und dem Gateanschluß des Thyristors 9 liegt. Der Gateanschluß des Hilfsthyristors 8 ist mit dem Emitter des Fototransistors 1 verbunden. Die Gate-Katoden-Widerstände 2 und 10 dienen in bekannter Weise zur Verbesserung des du/dt-Verhaltens.

Die Schaltungsanordnung dient zur Steuerung des Stroms in einer Last 11, die zwischen der Klemme A und einer Klemme mit der Betriebsspannung $U_B$ liegt. Zur Erläuterung der Funktion werden die drei wesentlichen Betriebszustände der Schaltung beschrieben:

1. An der Last liegt die Betriebsspannung $U_B$, die eine Wechselspannung ist. Erhält der Fototransistor 1 kein Licht als Steuersignal, so bleibt dieser gesperrt und der Hilfsthyristor 8 erhält keinen Strom. Er kann damit nicht zünden und auch der Hauptthyristor 9 bleibt gesperrt. Die Fotodiode 5 ist bezogen auf diejenige Spannung, die am Thyristor in Durchlaßrichtung anliegt, in Sperrichtung gepolt. Sie bildet einen sehr hohen Widerstand von einigen MOhm, so daß im Ruhezustand der Schaltung lediglich ein Ruhestrom in der Größenordnung von einigen µA oder noch weniger fließt.

2. Die Wechselspannung steigt ausgehend vom Nulldurchgang gegen positive Werte und der Fototransistor 1 erhält gleichzeitig mit der Fotodiode 5 ein Lichtsignal. Der Fototransistor wird damit eingeschaltet und sein Emitterstrom fließt zum Thyristor 8. Dies setzt voraus, daß der IGFET 4 gesperrt ist und der Basisstrom des Fototransistors nicht zur Klemme 35 abfließt. Dies wird dadurch erreicht, daß die Einsatzspannung des IGFET 4 höher gewählt wird als die Schwellspannung des Fototransistors 1. Damit, wird der IGFET 4 erst bei einer höheren Spannung eingeschaltet als der Fototransistor 1. Da der Fototransistor 1 jedoch schon leitend war, konnte der Thyristor 8 und damit der Thyristor 9 bereits zünden und die Last 11 erhält Strom.

3. Die Betriebsspannung ist ausgehend von Null bereits auf einen positiven Wert gestiegen, bei der die Thyristoren nicht mehr gezündet werden dürfen. Trifft dann den Fototransistor 1 und die Fotodiode 5 ein Lichtsignal, wird der IGFET 4 leitend gesteuert und leitet den Basisstrom des Fototransistors 1 zur Klemme K, d. h. zum Massepotential ab. Die Thyristoren können damit nicht gezündet werden. Das frühere Einschalten des IGFET 4 wird dadurch sichergestellt, daß seine Gate-Sourcekapazität kleiner als die Eingangskapazität des Fototransistors 1 ist. Ist die natürliche Eingangskapazität des Fototransistors 1 nicht groß genug, so wird zwischen seinen Basisanschluß und die Klemme 35 der Kondensator 7 geschaltet.

Die Zenerdiode 6 zwischen Gateanschluß G und Sourceanschluß S des IGFET 4 begrenzt die Gate-Sourcespannung auf einen für den IGFET 4 ungefährlichen Wert von z. B. 10 V. Seine Einsatzspannung kann auf bekannte Art und Weise durch die Dicke des Gateoxids und/oder die Dotierung des Substrats unter der Gateelektrode eingestellt werden.

Der zwischen Basisanschluß und Emitteranschluß des Fototransistors 1 liegende IGFET 3 stellt einen veränderbaren Widerstand dar, der im ausgeschalteten Zustand des Fototransistors einen kleinen Widerstand, im eingeschalteten Zustand jedoch einen hohen Widerstand repräsentiert. Dies bringt eine Erhöhung der Sperrspannungfestigkeit in unbeleuchteten Zustand und eine hohe Stromverstärkung im beleuchteten Zustand mit sich.

In der integrierten Anordnung nach Fig. 2 sind gleiche Teile wie in Fig. 1 mit gleichen Bezugszeichen versehen. Grundlage der integrierten Schaltung ist ein z. B. schwach negativ dotierter Halbleiterkörper 13. In diesem sind von links nach rechts der Fototransistor 1, die Fotodiode 5 und die Zenerdiode 6, der IGFET 3 und der IGFET 4 integriert.

Der Fototransistor 1 weist eine Basiszone 24 auf, die vom entgegengesetzten Leitungstyp wie der Halbleiterkörper 13 ist. Sie ist beispielsweise schwach p-dotiert. In die Basiszone 24 ist eine Emitterzone 25 vom ersten Leitungstyp eingebettet. Sie ist beispielsweise stark n-dotiert. Die Fotodiode hat eine in den Halbleiterkörper 13 eingebettete Zone 31 vom dem Halbleiterkörper entgegengesetzten Leitungstyp. Sie ist beispielsweise p-dotiert. Die Zone 31 bildet die Anodenzone der Fotodiode, der Halbleiterkörper 13 die Katodenzone. Für die IGFET 3 und 4 ist in den Halbleiterkörper 13 ein Substrat 14 eingebettet, das stärker und schwächer p-dotierte Bereiche hat. Die dickeren Teile des Substrats sind z. B. stärker und die dünneren Teile des Substrats schwächer p-dotiert. Die unterschiedlich stark p-dotierten Bereiche des Substrats 14 können jedoch auch gleich dick sein. Der IGFET 4 weist eine Drainzone 15 und eine Sourcezone 16 auf, letztere ist elektrisch mit dem Substrat 14 verbunden. Auf dem Substrat liegt eine Isolierschicht 17, z. B, aus Siliciumdioxid, die die Sourcezone und die Drainzone überlappt. Darüber ist beide Zonen überlappend eine Gateelektrode 18 z. B. aus dotiertem polykristallinem Silicium angeordnt. Die Gatezone des IGFET 4 bildet sich bei Anlegen einer Steuerspannung im Substrat 14 zwischen Drainzone 15 und Sourcezone 16 aus.

Der IGFET 3 vom Verarmungstyp weist eine Sourcezone 19 und eine Drainzone 20 vom ersten Leitungstyp auf, die in das Substrat 14 eingebettet sind. Zwischen den genannten Zonen ist eine Gatezone 21 eingebettet, die gleichen Leitungstyp wie die Zonen 19 und 20 hat, jedoch schwächer dotiert ist als diese. Die zugehörige Gateelektrode 23 wird durch eine dotierte polykristalline Siliciumschicht gebildet, die beide Zonen überlappt und auf einer Isolierschicht 22 sitzt. Die Einsatzspannung der IGFET 3 und 4 wird durch die Dicke der Oxidschichten 17, 22 und/oder den spezifischen Widerstand der Gatezone 21 bzw. den spezifischen Widerstand des Substrats bestimmt.

Die Zenerdiode 6 wird durch eine p-dotierte Zone 28, die Zone 31 der Fotodiode, eine gegenüber den Schichten 17, 22 dicke Isolierschicht 29 und eine Elektrode 30 gebildet. Die Isolierschicht 29 und die Elektrode 30 überlappen die Zone 31 und überdecken die Zone 28. Es reicht jedoch aus, wenn die Zone 28 von der Isolierschicht 29 und der Elektrode 30 auch nur überlappt wird. Die Zone 28 und die Elektrode 30 sind elektrisch miteinander verbunden, sie liegen beispielsweise auf Katodenpotential.

Die Zonen 28, 31 bilden in Verbindung mit der Isolierschicht 29 und der Elektrode 30 einen IGFET mit hoher Einsatzspannung. Steigt die Spannung am Gate 18 und damit das Potential der Zone 31 mit zunehmender Wechselspannung an, so schaltet der aus den Zonen 28 und 31 bestehende IGFET durch Kanalbildung an der Oberfläche des Halbleiterkörpers 13 zwischen den genannten Zonen ein. Damit wird das Potential am Gate 18 auf einen Wert begrenzt, der im wesentlichen durch den ohmschen Spannungsabfall zwischen den Zonen 28 und 31 bestimmt ist. Dieser Wert wird durch den Abstand der Zonen, die Dotierung zwischen diesen Zonen und durch die Breite der Zonen 26 und 31 bestimmt.

Die Zone 28 erfüllt in Verbindung mit der Elektrode 30 und einer zwischen der Elektrode 30 und dem Fototransistor gelegenen weiteren Elektrode 27 noch den Zweck, die vom Fototransistor ausgehende Raumladungszone derart zu verformen, daß möglichst viele der durch Licht erzeugten Ladungsträger zur Basiszone 24 des Fototransistors fließen.

Das Substrat 14 liegt zweckmäßigerweise an Masse, damit kapazitiv erzeugte Ströme abgeleitet werden können. Der Emitter 25 des Fototransistors 1 ist mit dem Gateanschluß des Hilfsthyristors 8 verbunden. Die Verbindungsklemme ist in den Fig. 1 und 2 mit 33 bezeichnet. Die Anodenspannung $+U_A$ wird der integrierten Schaltung über eine auf der Unterseite des Halbleiterkörpers 13 liegende Elektrode 32 zugeführt. Die in Fig. 1 dargestellten Thyristoren 8 und 9 können ebenfalls in integrierter Form auf dem gleichen Halbleiterkörper 13 untergebracht sein. Es können jedoch auch diskrete Bauelemente sein.

Die integrierte Anordnung kann z. B. folgende Dimensionierung haben:
Spezifischer Widerstand des Halbleiterkörpers: zwischen 30 und 50 Ohm cm, Dotierung der stark n-dotierten Zonen: $10^{20}$ cm$^{-3}$, ihre Dicke: 0,5 bis 2 µm, Dotierung der p-dotierten Zonen: zwischen $10^{17}$ und $10^{18}$ cm$^{-3}$, ihre Tiefe: zwischen 1 und 4 µm, Abstand der Zonen 28 Und 31 : 20 µm, Dicke der Isolierschicht 29: 1,5 µm. Die Zone 21 kann mit Arsen mit einer Dosis von $1 \cdot 10^{12}$ cm$^{-2}$ dotiert sein. Der Abstand der Zonen 19 und 20: zwischen 5 und 200 µm, die Dicke der Isolierschicht 22 des IGFET 3: 70 nm, Dotierung der schwach p-dotierten Teile: $10^{16}$ Atome cm$^{-3}$.

## Patentansprüche

1. Schaltungsanordnung zum Ansteuern mindestens eines an einer Wechselspannung liegenden Thyristors mit einem Fototransistor (1) und mit einem Hilfstransistor (4), der eine Zündung des Thyristors nur in der Nähe des Nulldurchgangs der Wechselspannung ermöglicht, gekennzeichnet durch die Merkmale:
   a) Die Kollektor-Emitterstrecke des Fototransistors (1) liegt zwischen einer von zwei Wechselspannungsklemmen und dem Gateanschluß des Thyristors,
   b) zwischen dem Basisanschluß des Fototransistors (1) und der zweiten Wechselspannungsklemme (35) liegt die Source-Drainstrecke eines IGFET (4) vom Anreicherungstyp,
   c) zwischen dem Gateanschluß des IGFET (4) und der ersten Wechselspannungsklemme liegt eine Fotodiode (5),
   d) die Fotodiode ist derart gepolt, daß sie in Sperrichtung vorgespannt ist, wenn am Thyristor (8, 9) Spannung in Durchlaßrichtung anliegt,
   e) dem IGFET (4) hat eine höhere Einsatzspannung als der Fototransistor (1) und eine geringere Eingangskapazität als dieser.

2. Schaltungsanordnung nach Anspruch 1, dadurch gekennzeichnet, daß zwischen Gateanschluß und Sourceanschluß des IGFET (4) eine Zenerdiode (6) angeschlossen ist.

3. Schaltungsanordnung nach Anspruch 1, dadurch gekennzeichnet, daß die Fotodiode (5) eine Zone (31) des ersten Leitungstyps hat, die in einem Halbleiterkörper (13) des zweiten Leitungstyps planar eingebettet ist, und daß die zweite Zone der Fotodiode (5) der Halbleiterkörper (13) ist.

4. Schaltungsanordnung nach Anspruch 3, dadurch gekennzeichnet, daß die Zenerdiode (6) eine Zone (28) des ersten Leitungstyps hat, die in den Halbleiterkörper (13) planar eingebettet ist, daß die genannte Zone (31) der Fotodiode und die Zone (28) der Zenerdiode (6) benachbart und im Abstand voneinander angeordnet sind, daß über beiden Zonen (28, 31) eine Elektrode (30) angeordnet ist, die beide Zonen zumindest überlappt, daß die Elektrode (30) gegen die Zone (31) der Fotodiode (5) isoliert ist, und daß die Elektrode (30) und die Zone (28) der Zenerdiode elektrisch miteinander verbunden sind und auf festem Potential liegen.

5. Schaltungsanordnung nach Anspruch 1, dadurch gekennzeichnet, daß zwischen dem Basisanschluß des Fototransistors (1) und der zweiten Wechselspannungsklemme (35) ein Kondensator (7) angeschlossen ist.

6 Schaltungsanordnung nach einem der Ansprüche 1 bis 3, dadurch gekennzeichnet, daß der Thyristor (9) einen zündstromverstärkenden Hilfsthyristor (8) aufweist und daß der Gateanschluß des Hilfstyristors (8) mit dem Emitteranschluß des Fototransistors (1) verbunden ist.

7. Schaltungsanordnung nach einem der Ansprüche 1 bis 3, dadurch gekennzeichnet, daß die erste Wechselspannungsklemme (34) über eine Diode (12) mit dem Anodenanschluß des Thyristors (8, 9) und die zweite Wechselspannungsklemme (35) mit dem Katodenanschluß des Thyristors elektrisch verbunden ist.

## Claims

1. Circuit arrangement for controlling at least one thyristor, which is connected to an alternating voltage, by means of a phototransistor (1) and by means of an auxiliary transistor (4) which enables the thyristor to be fired only in the vicinity of the zero transition of the alternating voltage, characterized by the following features:

a) the collector/emitter path of the phototransistor (1) is located between one of two alternating-voltage terminals and the gate connection of the thyristor,

b) the source-drain path of an IGFET (4) of the enrichment type is located between the base connection of the phototransistor (1) and the second alternating-voltage terminal (35),

c) a photodiode (5) is located between the gate connection of the IGFET (4) and the first alternating-voltage terminal,

d) the photodiode is polarized in such a manner that it is biassed in the reverse direction if voltage is present at the thyristor (8, 9) in the direction of conduction,

e) the IGFET (4) has a higher operating voltage than the phototransistor (1) and a lower input capitance than the latter.

2. Circuit arrangement according to Claim 1, characterized in that a Zener diode (6) is connected between the gate connection and source connection of the IGFET (4).

3. Circuit arrangement according to Claim 1, characterized in that the photodiode (5) has a zone (31) of the first type of conduction which is embedded in a planar manner in a semiconductor body (13) of the second type of conduction, and that the second zone of the photodiode, (5) is the semiconductor body (13).

4. Circuit arrangement according to Claim 3, characterized in that the Zener diode (6) has a zone (28) of the first type of conduction which is embedded in a planar manner in the semiconductor body (13), and the said zone (31) of the photodiode and the zone (28) of the Zener diode (6) are arranged adjacently and at a distance from one another, that an electrode (30) is arranged over both zones (28, 31) which at least overlaps the two zones, that the electrode (30) is insulated with respect to the zone (31) of the photodiode (5) and that the electrode (30) and the zone (28) of the Zener diode are electrically connected to one another and are at a fixed potential.

5. Circuit arrangement according to Claim 1, characterized in that a capacitor (7) is connected between the base connection of the phototransistor (1) and the second alternating-voltage terminal (35).

6. Circuit arrangement according to one of Claims 1 to 3, characterized in that the thyristor (9) exhibits a firing-current-amplifying auxiliary thyristor (8) and that the gate connection of the auxiliary thyristor (8) is connected to the emitter connection of the phototransistor (1).

7. Circuit arrangement according to one of Claims 1 to 3, characterized in that the first alternating-voltage terminal (34) is electrically connected to the anode connection of the thyristor (8, 9) via a diode (12) and the second alternating-voltage terminal (35) is electrically connected to the cathode connection of the thyristor.

## Revendications

1. Montage pour la commande d'au moins un thyristor raccordé à une tension alternative et comportant un phototransistor (1) et un transistor auxiliaire (4), qui permet l'amorçage du thyristor uniquement à proximité de l'annulation de la tension alternative, caractérisé par les caractéristiques suivantes:

a) la voie collecteur-émetteur du phototransistor (1) est située entre deux bornes de la tension alternative et la borne de grille du thyristor,

b) la voie source-drain d'un transistor IGFET (4) du type à enrichissement est située entre la borne de base du phototransistor (1) et la seconde borne (35) de la tension alternative,

c) une photodiode (5) est disposée entre la borne de grille du transistor IGFET (4) et la première borne de la tension alternative,

d) la voie de diode est polarisée de telle sorte qu'elle est polarisée en inverse lorsqu'une tension est appliquée dans le sens passant au thyristor (8, 9),

e) le transistor IGFET (4) possède une tension de déclenchement supérieure à celle du phototransistor (1) et une capacité d'entrée plus faible que ce dernier.

2. Montage suivant la revendication 1, caractérisé par le fait qu'une diode Zener (6) est branchée entre la borne de grille et la borne de source du transistor IGFET (4).

3. Montage suivant la revendication 1, caractérisé par le fait que la photodiode (5) comporte une zone (31) possédant le premier type de conductivité, qui est inséré selon le mode planar dans un corps semiconducteur (13) possédant le second type de conductivité, et que la seconde diode de la photodiode (5) constitue le corps semiconducteur (13).

4. Montage suivant la revendication 3, caractérisé par le fait que la diode Zener (6) comporte une zone (28) possédant le premier type de conductivité, qui est insérée selon le mode planar dans le corps semiconducteur (13), que ladite zone (31) de la photodiode et la zone (21) de la diode Zener (26) sont disposées au voisinage l'une de l'autre tout en étant réciproquement distantes, qu'au-dessus des deux zones (28, 31) est disposée une électrode (30) qui chevauche au moins les deux zones, que l'électrode (30) est isolée par rapport à la zone (31) de la photodiode (5), et que l'électrode (3) et la zone (28) de la diode Zener sont reliées électriquement entre elles et sont placées à un potentiel fixe.

5. Montage suivant la revendication 1, caractérisé par le fait qu'un condensateur (7) est branché entre la borne de base du phototransistor (1) et la seconde borne (31) de la tension alternative.

6. Montage suivant l'une des revendications 1 à 3, caractérisé par le fait que le thyristor (9) possède un thyristor auxiliaire (8) amplifiant le courant d'amorçage et que la borne de grille du thyristor auxiliaire (8) est reliée à la borne d'émetteur du phototransistor (1).

7. Montage suivant l'une des revendications 1 à 3, caractérisé par le fait que la première borne (34) de la tension alternative est reliée électriquement par l'intermédiaire d'une diode (12) à la borne d'anode du thyristor (8, 9) et que la seconde borne (35) de la tension alternative est reliée électriquement à la borne de cathode du thyristor.

# FIG 1

FIG 2